(19) **Europäisches Patentamt**
**European Patent Office**
**Office européen des brevets**

(11) **EP 1 405 436 B1**

(12) **EUROPÄISCHE PATENTSCHRIFT**

(45) Veröffentlichungstag und Bekanntmachung des Hinweises auf die Patenterteilung:
**31.10.2007 Patentblatt 2007/44**

(21) Anmeldenummer: **02729910.6**

(22) Anmeldetag: **24.05.2002**

(51) Int Cl.:
*H04B 7/005* (2006.01)       *H03M 13/00* (2006.01)

(86) Internationale Anmeldenummer:
**PCT/DE2002/001913**

(87) Internationale Veröffentlichungsnummer:
**WO 2003/005602 (16.01.2003 Gazette 2003/03)**

(54) **EINRICHTUNG UND VERFAHREN ZUR SKALIERUNG VON SOFT-OUTPUT-WERTEN EINER EMPFÄNGERSTRUKTUR**

DEVICE AND METHOD FOR SCALING SOFT-OUTPUT VALUES OF A RECEIVER STRUCTURE

DISPOSITIF ET PROCEDE DE MISE A L'ECHELLE DE VALEURS DE SORTIE LOGICIELLES D'UNE STRUCTURE DE RECEPTION

(84) Benannte Vertragsstaaten:
**AT BE CH CY DE DK ES FI FR GB GR IE IT LI LU MC NL PT SE TR**

(30) Priorität: **06.07.2001 DE 10132879**

(43) Veröffentlichungstag der Anmeldung:
**07.04.2004 Patentblatt 2004/15**

(73) Patentinhaber: **Infineon Technologies AG 81669 München (DE)**

(72) Erfinder:
• **BECKER, Burkhard 85737 Ismaning (DE)**
• **YANG, Bin 70550 Stuttgart (DE)**

(74) Vertreter: **Lange, Thomas et al Patentanwälte Lambsdorff & Lange Dingolfinger Strasse 6 81673 München (DE)**

(56) Entgegenhaltungen:
**WO-A-00/74247          US-A- 5 577 068**

• **ANONYMOUS: "Apparatus for Performing Division. November 1974." IBM TECHNICAL DISCLOSURE BULLETIN, Bd. 17, Nr. 6, 1. November 1974 (1974-11-01), Seiten 1582-1586, XP002213977 New York, US**

**Beschreibung**

Die Erfindung betrifft eine Einrichtung und ein Verfahren zur Skalierung von Soft-Output-Werten einer Empfängerstruktur, insbesondere eines Entzerrers, eines Kanaldekodierers oder anderer Empfängerstrukturen wie beispielsweise einer RAKE-Schaltung.

Entzerrer und Kanaldekodierer werden im Bereich der Datenübertragung verwendet, um Signalverzerrungen, die das ausgesendete Signal bei der Übertragung über einen Kanal erleidet, aus dem empfangenen Signal wieder herauszurechnen. Mit dem Viterbi-Algorithmus steht ein leistungsfähiges und vielbenutztes rekursives Rechenverfahren zur Verfügung, welches sowohl für die Entzerrung als auch für die Kanaldekodierung eingesetzt werden kann.

Speziell bei der Entzerrung hat es sich als vorteilhaft erwiesen, zusätzlich zu den hart entschiedenen (entzerrten) Datensymbolen sogenannte Soft-Output-Werte zu erzeugen. Jedem Bit eines hart entschiedenen Datensymbols ist ein Soft-Output-Wert zugeordnet und gibt eine Wahrscheinlichkeit dafür an, ob es sich bei diesem Bit um eine 0 oder eine 1 handelt. Die der Entzerrung nachfolgende Kanaldekodierung wird bei Verwendung von Soft-Output-Werten deutlich verbessert.

Soft-Output-Werte werden nicht nur von Entzerrern sondern auch von anderen Empfängerstrukturen, beispielsweise auch dem Kanaldekodierer oder einer RAKE-Schaltung geliefert.

Nach der Berechnung der Soft-Output-Werte müssen diese skaliert werden, das heisst durch eine Größe, die einer ermittelten Rauschvarianz entspricht, geteilt werden. Die Skalierung der Soft-Output-Werte wird bisher in einem Firmwaregesteuerten Prozessor durchgeführt. Dies bietet den Vorteil, dass unterschiedlichen Anforderungen in Bezug auf die Genauigkeit der Rechenergebnisse flexible Rechnung getragen werden kann.

Besonders im Bereich des Mobilfunks besteht jedoch ein Nachteil eines solchen Vorgehens darin, dass Firmware-gesteuerte Rechenprozesse verhältnismäßig zeitaufwendig sind und darüber hinaus die Leistungsanforderungen an den Prozessor erhöhen. Letzteres bewirkt eine Zunahme der MIPS-Anforderungen sowie eine Zunahme des Strombedarfs des Prozessors, was speziell für Mobilstationen von gravierendem Nachteil ist.

Die den nächstliegenden Stand der Technik darstellende Druckschrift US 5,577,068 A behandelt einen Viterbi-Entzerrer, in welchem durch eine Skaliereinheit digitale Soft-Output-Werte in Abhängigkeit einer ermittelten Rauschleistung skaliert werden. Die Skalierung unter Verwendung des ermittelten Skalierwerts erfolgt hierbei für mehrere, aufeinanderfolgende Soft-Output-Werte.

In der Druckschrift WO 00/74247 A1 wird eine Decodier-Architektur behandelt, die eine Empfänger- und eine Decodiereinheit umfasst. Die für die Kanaldecodierung verwendeten Soft-Output-Werte werden hierbei von einer Multiplikationseinheit skaliert, wobei der Skalierwert für mehrere, aufeinanderfolgende Soft-Output-Werte identisch ist.

Der Erfindung liegt die Aufgabe zugrunde, eine aufwandsgünstige und Energieressourcen-schonende Skalierung von Soft-Output-Werten zu ermöglichen.

Die Aufgabenstellung wird durch die Merkmale der unabhängigen Ansprüche gelöst.

Gemäß Anspruch 1 umfasst die erfindungsgemäße Einrichtung zur Skalierung von Soft-Output-Werten einer Empfängerstruktur, insbesondere eines Entzerrers oder Kanaldekodierers, ein Berechnungsmittel zum Berechnen eines Skalierwertes für die Skalierung von digitalen Soft-Output-Werten der Empfängerstruktur. Darüber hinaus beinhaltet die Einrichtung einen Software-gesteuerten Prozessor zur Programmierung einer Arithmetik-Einheit, welcher bei Erhalt des berechneten Skalierwertes eine Umprogrammierung der Arithmetik-Einheit durch Berechnung von Steuerparametern durchführt, die von diesem berechneten Skalierwert abhängig sind. Ferner umfasst die Einrichtung die in Hardware ausgeführte Arithmetik-Einheit, welche die digitalen Soft-Output-Werte in Abhängigkeit von den berechneten Steuerparameter skaliert, wobei die Arithmetik-Einheit einen ersten Skalierschaltkreis, der einen digitalen Eingangswert um eine von dem berechneten Skalierwert abhängige Anzahl von Stellen nach rechts oder links verschiebt und einen zweiten Skalierschaltkreis, welcher einen digitalen Eingangswert mit einem Korrekturfaktor $\left(1 + \sum_{i=1}^{p} m_i \cdot 2^{-i}\right)$ multipliziert, wobei p eine ganze Zahl gleich oder größer als 1 ist und $m_i$ in Abhängigkeit von dem berechneten Skalierwert die Werte 0 oder 1 annehmen kann, umfasst. Der zweite Skalierschaltkreis besteht aus p parallel angeordneten Stellenverschiebern und einem Addierer mit mindestens p+1 Eingängen.

Der erste Skalierschaltkreis ermöglicht eine Grob-Skalierung durch Division des erhaltenen Soft-Output-Wertes durch eine geeignete Potenz zur Basis 2, während durch die Anzahl der Stellenverschieber des zweiten Skalierschaltkreises die maximale Genauigkeit des Verfahrens bestimmt und durch die Programmierung verändert wird.

Infolge der Verwendung einer Hardware-Arithmetik-Einheit zur Durchführung der Skalieroperationen belasten diese nicht den Prozessor und machen sich daher auch nicht in der vom Prozessor pro Zeitschritt benötigten Zyklenanzahl bemerkbar. Es wird lediglich nach jeder Neuberechnung des Skalierwertes (z.B. ein Mal pro Zeitschlitz im EDGE-(Enhanced Data Services for GSM Evolution-)Standard) eine bestimmte Zyklenanzahl zur Umprogrammierung der Hardware-Arithmetik-Einheit benötigt, welche jedoch geringer ist als die über denselben Zeitraum bei einer Firmware-bezogenen Abarbeitung der Skalieroperationen benötigte Zyklenanzahl.

Eine vorteilhafte Ausgestaltung der erfindungsgemäßen Einrichtung kennzeichnet sich dadurch, dass die Arithmetik-Einheit eine erste Sättigungsstufe umfasst, welche eine insbesondere fest vorgegebene Begrenzung des Wertebereichs der von dem ersten Skalierschaltkreis ausgegebenen Bitworte bewirkt. Hierdurch wird die Wortbreite der von dem zweiten Skalierschaltkreis zu verarbeitenden Bitworte reduziert.

Vorzugsweise umfasst die Arithmetik-Einheit eine zweite Sättigungsstufe, welche eine insbesondere wählbare Begrenzung des Wertebereichs des von dem zweiten Skalierschaltkreis ausgegebenen Bitworte bewirkt. Dadurch kann die Wortbreite der skalierten Soft-Output-Werte nach Wunsch bzw. gestellten Anforderungen vorgegeben werden.

Vorzugsweise ist die erfindungsgemäße Einrichtung in einem Mobilfunkempfänger enthalten und die Empfängerstruktur ein Entzerrer, insbesondere Viterbi-Entzerrer, ein Kanaldekodierer, insbesondere Viterbi-Kanaldekodierer, oder eine RAKE-Schaltung.

Die Erfindung wird nachfolgend anhand eines Ausführungsbeispiels für einen Entzerrer unter Bezugnahme auf die Zeichnung erläutert; in dieser zeigt:

Fig. 1 eine Darstellung von Funktionsblöcken zur Erläuterung der allgemeinen Struktur eines Viterbi-Entzerrers;

Fig. 2 ein Blockschaltbild eines Ausführungsbeispiels einer erfindungsgemäßen Skaliereinrichtung für Soft-Output-Werte; und

Fig. 3 ein Ablaufdiagramm als Beispiel für das erfindungsgemäße Verfahren.

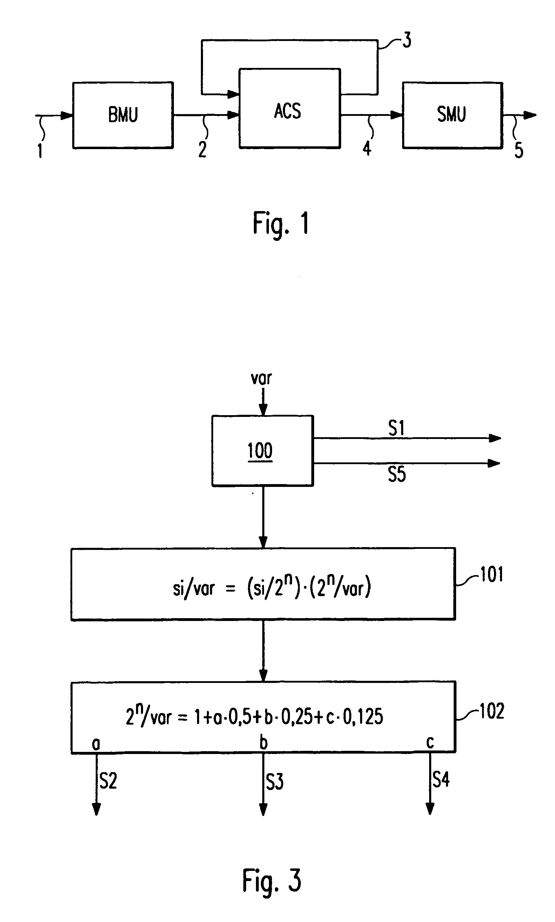

Fig. 1 zeigt den generellen Aufbau eines Viterbi-Entzerrers bestehend aus einer Einheit zur Berechnung von Übergangsmetriken BMU (Branch Metric Unit), einer Einheit zur Durchführung von ACS-(ADD-COMPARE-SELECT-) Operationen, ACS, und einer Einheit SMU (Survivor Memory Unit) zur Pfadermittlung mittels Durchführung von Trace-Back-Operationen.

Die generelle Funktionsweise von Viterbi-Entzerrern ist bekannt und wird hier lediglich kurz erläutert:

Allgemein liegt der Viterbi-Entzerrung die Idee zugrunde, durch ein rekursives Verfahren einen kürzesten Weg durch ein Zustandsdiagramm (Trellis-Diagramm) zu ermitteln, in welchem die Zustände eines Schieberegisters über der diskreten Zeit (mit dem Zeitschrittindex k) aufgetragen sind. Das Schieberegister repräsentiert das Kanalgedächtnis. Es wird pro Zeitschritt ein Datensymbol in das entsprechende Schieberegister eingeschoben und dadurch der Zustand des Schieberegisters verändert. Die Werte der Datensymbole, die dem jeweiligen Schieberegister in jedem Zeitschritt zugeführt werden, kommen als mögliche Empfangswerte in Frage. Die Wahrscheinlichkeit für das Auftreten dieser Datensymbolwerte als Empfangswerte wird mittels der Viterbi-Rekursion Zeitschritt für Zeitschritt bestimmt. Dabei berechnet die Einheit BMU für jeden möglichen Übergang im Trellis-Diagramm Übergangswahrscheinlichkeiten, die als Übergangsmetrikwerte (in der Literatur manchmal auch als Metrikinkrementwerte) bezeichnet werden. Die Berechnung dieser Übergangsmetrikwerte beruht auf der dem Empfänger aktuell zur Verfügung stehenden Information, d.h. auf den empfangenen Datensymbolen und den von einem Kanalschätzer fortlaufend ermittelten Kanalparametern. Die empfangenen Datensymbole werden der Einheit BMU über eine Datenverbindung 1 zugeführt.

Die in der Einheit BMU berechneten Übergangsmetrikwerte werden über die Datenverbindung 2 der ACS-Einheit zugeführt. In der ACS-Einheit werden die Übergangsmetrikwerte den jeweiligen Zustandsmetriken der Vorgänger-Zustände hinzuaddiert (ADD-Operation) und es werden die auf diese Weise erhaltenen Summen verglichen (COMPARE-Operation). Derjenige Übergang, dessen Summe aus Übergangsmetrikwert und Metrik des Vorgänger-Zustands minimal ist, wird ausgewählt (SELECT-Operation) und bildet die Verlängerung des in den Vorgänger-Zustand mündenden Pfades in den Zielzustand. Die ACS-Operationen bilden das Kernstück des Viterbi-Algorithmus.

Bei der Viterbi-Entzerrung wird der ACS-Schritt innerhalb jedes Zeitschrittes zyklisch für sämtliche Zielzustände oder für bestimmte Gruppen von Vorgänger- und Zielzuständen (sog. Butterflies) ausgeführt. Dies ist durch die Schleife 3 in Fig. 1 angedeutet.

Nachdem für einen bestimmten Zeitschritt im Trellis-Diagramm sämtliche Metriken bestimmt sind, werden die zugehörigen dominierenden Zustandsübergänge der Einheit SMU über die Datenverbindung 4 mitgeteilt. Die Einheit SMU führt eine Trace-Back-Operation zur Ermittlung eines um eine bestimmte Anzahl von Zeitschritten zurückliegenden Datensymbols durch. Dieses wird über eine Datenverbindung 5 ausgegeben. Der Trace-Back-Operation liegt zugrunde, dass im Trellis-Diagramm die einzelnen Pfade in zeitlicher Rückwärtsrichtung konvergieren, d.h., dass Datensymbole, die für einen länger zurückliegenden Übergang ermittelt wurden, für überlebende Pfade eine höhere Sicherheit aufweisen als für abgebrochene Pfade (ob ein Pfad überlebt oder nicht, stellt sich eben erst nach Abarbeitung einer bestimmten Anzahl weiterer Zeitschritte heraus).

Im folgenden wird die Berechnung von Soft-Output-Werten anhand des Beispiels von 8PSK-(Phase Shift Keying-)Datensymbolen, wie sie beispielsweise im EDGE-Standard verwendet werden, beschrieben.

Ein entschiedenes 8PSK-Datensymbol $x_k$ zum Zeitschritt k wird durch ein Bit-Tripel (b0,b1,b2) dargestellt, wobei bi=0 oder 1 für i=0,1,2 ist. Für jeden Zeitschritt k wird z.B. in der Einheit ACS für jede Komponente bi des 8PSK-Datensymbols $x_k$ ein Soft-Output-Wert berechnet, welcher angibt, mit welcher Wahrscheinlichkeit die entsprechende Komponente des hart entschiedenen Datensymbols z.B den Wert 1 aufweist. Der Softbit-Wert si zum Bit bi errechnet sich nach der Gleichung

$$\mathtt{si=min((M_{k-1}(m)+I_k(m\rightarrow m'))\,|\,bi=1)-min((M_{k-1}(m)+I_k(m\rightarrow m'))\,|\,bi=0)}$$

$$\mathtt{f\ddot{u}r\ i=\ 0,1,2.}$$

Hierbei bezeichnet die Schreibweise $I_k(m\rightarrow m')$ allgemein den Übergangsmetrikwert für einen Zustandsübergang vom Zustand m zum Zeitschritt k-1 in den Zielzustand m' zum Zeitschritt k (m und m' bezeichnen einen Index, mit welchem die im Trellis-Diagramm betrachteten $N_{Trellis}$ Zustände indiziert sind, d.h. m,m' = 1,..,$N_{Trellis}$) . $M_k(m)$ bezeichnet die Metrik eines Zustands m zum Zeitschritt k. Im Rekursionsschritt des Viterbi-Algorithmus für den k-ten Zeitschritt sind alle Metriken $M_{k-1}(m)$ vom vorhergehenden Rekursionsschritt und die Übergangsmetrikwerte $I_k(m\rightarrow m')$ nach Durchführung der Berechnung der Einheit BMU bekannt. Die Minimumbildung in der obigen Gleichung wird über sämtliche möglichen Zustandsübergänge m→m' durchgeführt.

Die auf diese Weise berechneten Soft-Output-Werte si müssen skaliert werden, d.h. durch die bei der Kanalschätzung ermittelte Rauschvarianz dividiert werden.

Diese Division wird üblicherweise von einem Prozessor durchgeführt. Sie würde bei dem hier betrachteten Beispiel (8PSK-Datensymbole) für einen EDGE-Zeitschlitz etwa 3×116×4 (Anzahl der Soft-Output-Werte pro Datensymbol × Anzahl der Datensymbole pro Zeitschlitz × Zyklen pro reeller Division) erfordern.

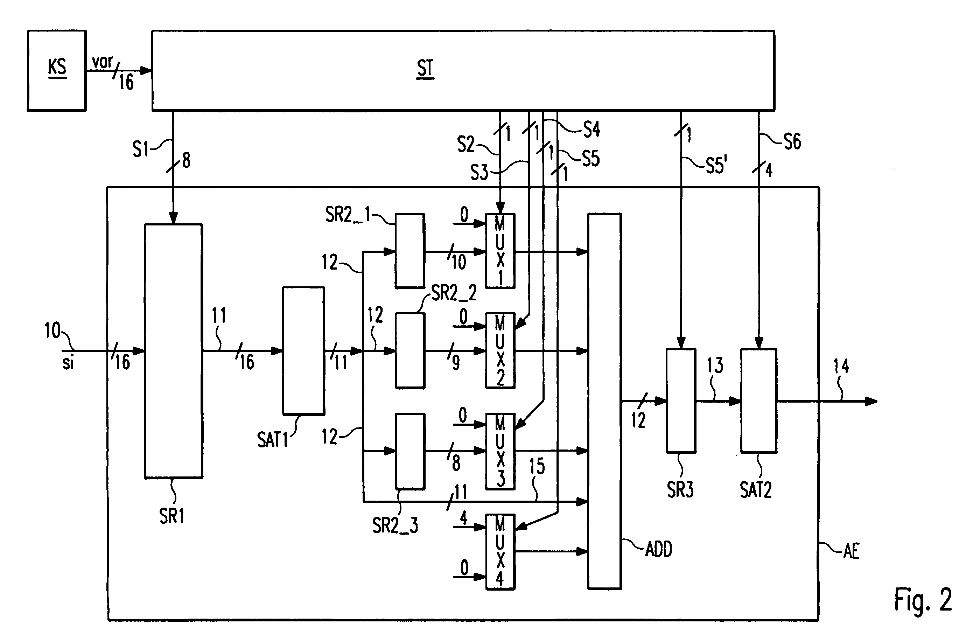

Gemäß der Erfindung wird die Skalierung der Soft-Output-Werte durch einen schnellen Hardware-Arithmetikschaltkreis durchgeführt. Ein Ausführungsbeispiel eines solchen Schaltkreises ist in Fig. 2 dargestellt.

Eine Arithmetik-Einheit AE umfasst ein erstes Schieberegister SR1, welchem über einen Eingang 10 der Arithmetik-Einheit AE die Soft-Output-Werte si (bei einer 8PSK-Modulation drei Stück pro Zeitschritt k) zugeführt werden. Die Wortbreite der Soft-Output-Werte kann beispielsweise 16 Bit betragen. Das erste Schieberegister SR1 nimmt eine Verschiebung der erhaltenen Datenworte si um eine einstellbare Anzahl n von Stellen nach rechts vor. Der Wertebereich für n kann beispielsweise n=1, ..., 8 bei einer Verschiebung nach rechts betragen. Die Zahl n wird dem ersten Schieberegister SR1 über eine erste Steuerdatenverbindung S1 mitgeteilt. Die Wortbreite der Steuerdatenverbindung S1 kann beispielsweise 8 Bits betragen, so dass eine Umprogrammierung des ersten Schieberegisters SR1 stets durch Setzen eines einzigen Bits möglich ist.

Eine ebenfalls mögliche Verschiebung der erhaltenen Datenworte nach links umfasst in der Regel nur ein oder zwei Stellen, da dieser Fall lediglich bei sehr gutem Signal-zu-Rausch-Verhältnissen auftritt.

Die Stellenverschiebung um n Stellen muss nicht durch ein Schieberegister im klassischen Sinn erfolgen, bei welchem die einzelnen Datenbits von einer Speicherzelle in eine andere Speicherzelle geschoben werden, sondern kann ohne eine Umspeicherung von Datenbits auch durch ein um n Stellen versetztes Auslesen einer Speicherzellenzeile mittels eines variablen Adresszeigers erfolgen.

Das um n Dualstellen nach rechts (oder links) verschobene Datenwort wird über eine Datenverbindung 11 einer ersten Sättigungsstufe SAT1 zugeführt. Die erste Sättigungsstufe SAT1 nimmt eine Begrenzung der Wortbreite auf eine fest vorgegebene Größe, z.B. 11 Bits, vor. Die Begrenzung der Wortbreite auf 11 Bits entspricht einem maximalen Wertebereich von [-1.023,+1.023], wobei ein Bit als Vorzeichen-Bit fungiert. In dem Beispiel erfolgt die Sättigung symmetrisch zum Nullpunkt.

Die stellenverschobenen und gesättigten Datenworte (Soft-Output-Werte) werden über Datenverbindungen 12 drei parallel zueinander angeordneten zweiten Schieberegistern SR2_1, SR2_2 und SR2_3 zugeleitet. Die zweiten Schieberegister SR2_1, SR2_2 und SR2_3 nehmen eine Stellenverschiebung um ein Bit (SR2_1) bzw. zwei Bits (SR2_2) bzw. drei Bits (SR2_3) nach rechts vor. Die ein bzw. zwei bzw. drei niederwertigsten Bits werden dabei verworfen, so dass hinter dem Schieberegister SR2_1 ein Datenwort der Wortbreite 10, hinter dem Schieberegister SR2_2 ein Datenwort der Wortbreite 9 und hinter dem Schieberegister SR2_3 ein Datenwort der Wortbreite 8 vorliegt.

Diese Datenworte werden jeweils Multiplexern MUX1, MUX2 und MUX3 zugeleitet. Die Multiplexer MUX1, MUX2 und MUX3 sind einzeln über Steuerdatenleitungen S2, S3 und S4 der Wortbreite 1 ansteuerbar.

Die Wirkungsweise der Multiplexer MUX1, MUX2, MUX3 besteht darin, je nach Ansteuerung entweder den Wert 0 oder das von dem entsprechenden zweiten Schieberegister SR2_1, SR2_2, SR2_3 erhaltene Datenwort am Ausgang bereitzustellen.

Die Multiplexerausgänge werden einem Addierer ADD zugeleitet. Zusätzlich wird dem Addierer ADD über eine Datenverbindung 15 das von der ersten Sättigungsstufe SAT1 ausgegebene stellenverschobene und gesättigte Datenwort zugeführt.

Ein weiteres Eingangssignal wird dem Addierer ADD von einem weiteren Multiplexer MUX4 eingegeben, welcher je nach Ansteuerung über eine Steuerdatenleitung S5 der Wortbreite 1 selektiv ein Bitwort des Wertes 4 oder des Wertes 0 liefert.

Am Ausgang des Addierers ADD kann die Wortbreite z.B. 12 Bit betragen. Das die Summe der einzelnen Eingänge repräsentierende Datenwort wird einem dritten Schieberegister SR3 mit variabler Stellenverschiebung zugeleitet. Die Ansteuerung des dritten Schieberegisters SR3 über eine Steuerdatenleitung S5' ist mit der Ansteuerung des Multiplexers MUX4 gekoppelt. Das dritte Schieberegister SR3 nimmt eine Stellenverschiebung um drei Stellen nach rechts vor, wenn der Multiplexer MUX4 den Wert 4 ausgibt, und unterläßt eine Stellenverschiebung, sofern der Multiplexer MUX4 den Wert 0 ausgibt.

Der Ausgang des dritten Schieberegisters SR3 ist über eine Datenverbindung 13 mit dem Eingang einer zweiten Sättigungsstufe SAT2 verbunden. Die zweite Sättigungsstufe SAT2 nimmt eine Reduzierung der Wortbreite der erhaltenen Datenwörter auf eine wählbare Wortbreite, das heisst einen wählbaren Wertebereich vor. Die Anwahl des gewünschten Wertebereichs erfolgt entsprechend einem Steuerparameter j über eine Steuerdatenverbindung S6. Beispielsweise kann eine Sättigung auf eine Wortbreite von 5 Bits (Wertebereich [-15, +15]), 6 Bits (Wertebereich [-31, +31]), 7 Bits (Wertebereich [-63, +63]) oder 8 Bits (Wertebereich [-127, +127]) vorgesehen sein. Ein Bit wird dabei stets als Vorzeichen-Bit verwendet. Man sieht, dass hier ebenfalls eine Sättigung symmetrisch zum Nullpunkt gewählt wurde.

Bei der Wahlmöglichkeit von vier unterschiedlichen Wertebereichen für einen Ausgang 14 der Arithmetik-Einheit AE kann die Ansteuerung der zweiten Sättigungsstufe SAT2 über eine Steuerdatenverbindung S6 der Wortbreite 4 durch Setzen eines einzigen Steuer-Bits erfolgen.

Die Steuerdatenverbindungen bzw. -leitungen S1, S2, ..., S6 stehen eingangsseitig mit einer Steuerung ST in Verbindung, deren Aufgabe die Programmierung der Arithmetik-Einheit AE ist. Zu diesem Zweck wird der Steuerung ST ein (nominaler) Skalierwert var zugeführt, welcher in einem Kanalschätzer KS ermittelt und fortlaufend aktualisiert wird. Der Skalierwert var ist die Rauschvarianz oder eine mit dieser im Zusammenhang stehende Größe.

Nachfolgend wird die Wirkungsweise der in Fig. 2 dargestellten Schaltung näher erläutert. Hierzu wird auch auf das in Fig. 3 dargestellte Ablaufdiagramm Bezug genommen.

Nachdem der Steuerung ST ein aktueller Skalierwert var z.B. der Wortbreite 16 zugeleitet wurde, was z.B. einmal pro Zeitschlitz erfolgt, besteht die Aufgabe der Steuerung ST allgemein darin, eine geeignete Ansteuerung der Arithmetik-Einheit AE vorzunehmen, derart, dass diese eine möglichst genaue Ermittlung des Quotienten si/var durchführt. Zu diesem Zweck wird in einem ersten Schritt 100 eine Approximation des Skalierwertes var durch eine Potenz zur Basis 2, das heisst durch eine Zahl $2^n$, vorgenommen. Der dabei ermittelte Wert n wird, wie bereits erwähnt, über die Signalverbindung S1 dem ersten Schieberegister SR1 zugeleitet und bewirkt infolge der Stellenverschiebung eine Division des Soft-Output-Wertes durch die ganze Zahl $2^n$. Damit ist eine Grobskalierung erreicht. Man kann auch negative Zahlen n verwenden, was einer Multiplikation (Linksverschiebung) mit $2^n$ entspricht.

Ferner wird im Schritt 100 festgelegt, ob mittels des Multiplexers MUX4 und des dritten Schieberegisters SR3 eine Rundungsoperation der skalierten Soft-Output-Werte durchgeführt werden soll. Ist dies der Fall, wird über die Steuerdatenleitung S5 der Multiplexer MUX4 sowie über die Steuerdatenleitung S5' das dritte Schieberegister SR3 aktiviert. In diesem Fall erhöht sich die von dem Addierer ADD ausgegebene Summe um den Wert 4 und wird vom dritten Schieberegister SR3 um drei Dualstellen nach rechts verschoben.

In einem nächsten Schritt 101 wird eine Zerlegung des Ausdruckes für den skalierten Soft-Output-Wert in der Form

$$si/var = (si/2^n) \cdot (2^n/var)$$

vorgenommen. Der erste Produktterm entspricht der bereits erläuterten Grobskalierung, der zweite Produktterm wird zur Bestimmung der Ansteuersignale S2, S3 und S4 für die aus den Schieberegistern SR2_1, SR2_2, SR2_3, Multiplexern MUX1, MUX2, MUX3 und dem Addierer ADD bestehenden Feinskalierungsstufe herangezogen.

Zur Feinskalierung werden in Schritt 102 gemäß der Gleichung

$$2^n/var = 1 + a \cdot 0,5 + b \cdot 0,25 + c \cdot 0,125 + ...$$

die Steuer-Bits a, b und c ermittelt.

Das Steuer-Bit a steuert über die Steuerdatenleitung S2 den Multiplexer MUX1, das Steuer-Bit b steuert über die Steuerdatenleitung S3 den Multiplexer MUX2 und das Steuer-Bit c steuert über die Steuerdatenleitung S4 den Multiplexer MUX3.

Die Punkte in obiger Gleichung sollen andeuten, dass weitere Steuer-Bits d, e usw. bei der fraktionalen Zerlegung des Ausdrucks $2^n$/var bestimmt werden können und zur Ansteuerung einer dementsprechend ausgelegten Arithmetik-Einheit AE mit entsprechend mehr Schieberegister/Multiplexer-Stufen SR2_1/MUX1, SR2_2/MUX2, SR2_3/MUX3 verwendet werden können.

Die Steuer-Bits a, b, c, ... geben ein Maß für die Abweichung der approximierten Zweier-Potenz $2^n$ von dem Skalierwert var an. Die Feinskalierungsstufe nimmt somit eine Korrektur des bei der Grobskalierung (Schieberegister SR1) erhaltenen Wertes durch mögliche Additionen der Werte 1/2, 1/4, 1/8, ... vor.

Sofern die optionale Rundungsoperation durchgeführt wird, entspricht die im Schritt 101 beschriebene Zerlegung der Gleichung

$$\text{si/var} = (2^3 \cdot \text{si}/2^n) \cdot (2^n/\text{var})/2^3.$$

Für die Umprogrammierung der Arithmetik-Einheit AE werden bei dem hier dargestellten Ausführungsbeispiel etwa 50 Prozessorzyklen benötigt.

Es wird darauf hingewiesen, dass der Programmierung der Arithmetik-Einheit AE unterschiedliche Algorithmen zugrunde liegen können. Das heisst, die in Fig. 3 im Schritt 101 dargestellte Zerlegung des Ausdrucks si/var ist optional. Die Arithmetik-Einheit AE kann auch für andere algorithmische Ansätze in identischer Form verwendet werden.

Ein alternativer algorithmischer Ansatz besteht beispielsweise darin, dass die Steuerung ST zunächst die relative Abweichung der approximierten Rauschvarianz von der berechneten Rauschvarianz var prüft und die Arithmetik-Einheit AE in Abhängigkeit von dem relativen Differenzwert zwischen der approximierten Rauschvarianz und der berechneten Rauschvarianz var ansteuert. Dazu wird der relative Differenzwert mit vorgegebenen Schwellen verglichen und bei Überschreitung der Schwellen werden die gezeigten Schieberegister/Multiplexer-Stufen SR2_1/MUX1, SR2_2/MUX2, SR2_3/MUX3 für die Erzeugung der Korrekturwerte des approximierten skalierten Soft-Output-Wertes aktiviert.

Sämtlichen algorithmischen Ansätzen ist gemeinsam, dass in der Hardware (unter der Voraussetzung einer Wortbreite von 16 Bit am Eingang 10 der Arithmetik-Einheit AE und für den Skalierwert var) keine vollständige $16 \times 16$ Bit Multiplikation oder Division erforderlich ist, sondern eine approximierte Skalierung durch Schieberegister, Multiplexer, Addierer und gegebenenfalls Sättigungsstufen erreicht wird. Der Approximation liegt dabei das Prinzip zugrunde, dass bei der Skalierung nicht der volle Informationsgehalt des Skalierwertes var benutzt wird, sondern lediglich eine gewisse Anzahl der höherwertigen Bits von var für die näherungsweise Bestimmung des Quotienten si/var verwendet wird. Die Arithmetik-Einheit AE profitiert unmittelbar von dieser reduzierten Bitbreite.

**Patentansprüche**

1. Einrichtung zur Skalierung von Soft-Output-Werten einer Empfängerstruktur, wobei die Einrichtung ein Berechungsmittel (KS) zum Berechnen eines Skalierwertes (var) für die Skalierung von digitalen Soft-Output-Werten (si) der Empfängerstruktur umfasst,
**dadurch gekennzeichnet,**
**dass** die Skalierungseinrichtung ferner umfasst:

- einen Software-gesteuerten Prozessor (ST) zur Programmierung einer Arithmetik-Einheit (AE), welcher bei Erhalt des berechneten Skalierwertes (var) von dem Berechnungsmittel (KS) eine Umprogrammierung der Arithmetik-Einheit (AE) durch Berechnung von Steuerparametern (n, $m_i$, j), die von diesem berechneten Skalierwert abhängig sind, durchführt; und
- die in Hardware ausgeführte Arithmetik-Einheit (AE) zum Skalieren der digitalen Soft-Output-Werte (si) in Abhängigkeit von den berechneten Steuerparameter (n, $m_i$, j), wobei die Arithmetik-Einheit (AE) einen ersten Skalierschaltkreis (SR1), der einen digitalen Eingangswert um eine von dem berechneten Skalierwert (var) abhängige Anzahl (n) von Stellen nach rechts oder links verschiebt, und einen zweiten Skalierschaltkreis (SR2_1/MUX1, SR2_2/MUX2, SR2_3/MUX3, ADD), welcher den verschobenen digitalen Eingangswert mit einem Korrekturfaktor $1 + \sum_{i=1}^{p} m_i \cdot 2^{-i}$ multipliziert, wobei p eine ganze Zahl gleich oder größer als 1 ist und $m_i$ in Abhängigkeit von dem berechneten Skalierwert (var) die Werte 0 oder 1 annehmen kann, umfasst, wobei der zweite Skalierschaltkreis (SR2_1/MUX1, SR2_2/MUX2, SR2_3/MUX3, ADD) p parallel angeordnete Stellenverschieber und einen Addierer (ADD) mit mindestens p+1 Eingängen aufweist.

2. Einrichtung nach Anspruch 1,
**dadurch gekennzeichnet,**

- **dass** die Arithmetik-Einheit (AE) eine erste Sättigungsstufe (SAT1) umfasst, welche eine insbesondere fest vorgegebene Begrenzung des Wertebereichs der von dem ersten Skalierschaltkreis (SR1) ausgegebenen Bitworte bewirkt.

3. Einrichtung nach Anspruch 1 oder 2,
**dadurch gekennzeichnet,**

- **dass** p = 2 oder 3 ist.

4. Einrichtung nach einem der vorhergehenden Ansprüche,
**dadurch gekennzeichnet,**

- **dass** die Arithmetik-Einheit (AE) eine zweite Sättigungsstufe (SAT2) umfasst, welche eine insbesondere wählbare Begrenzung (j) des Wertebereichs der von dem zweiten Skalierschaltkreis (SR2_1/MUX1, SR2_2/MUX2, SR2_3/MUX3, ADD) ausgegebenen Bitworte bewirkt.

5. Einrichtung nach Anspruch 4,
**dadurch gekennzeichnet,**

- **dass** die zweite Sättigungsstufe (SAT2) derart ausgelegt ist, dass mehr als zwei, insbesondere vier Wertebereichsbegrenzungen (j) einstellbar sind.

6. Einrichtung nach Anspruch 4 oder 5,
**dadurch gekennzeichnet,**

- **dass** in der Arithmetik-Einheit (AE) insbesondere im Signalweg zwischen dem ersten Skalierschaltkreis (SR1) und der zweiten Sättigungsstufe (SAT2) eine Rundungseinheit (MUX4, SR3) vorhanden ist, welche ausgelegt ist, einem Digitalwort den Wert $2^q$ hinzuzuaddieren und nachfolgend eine Stellenverschiebung des Digitalwortes um q+1 Stellen nach rechts vorzunehmen, wobei q eine ganze Zahl größer oder gleich 2 ist.

7. Einrichtung nach einem der vorhergehenden Ansprüche,
**dadurch gekennzeichnet,**

- **dass** die Empfängerstruktur ein Entzerrer, insbesondere Viterbi-Entzerrer, ein Kanaldekodierer, insbesondere Viterbi-Kanaldekodierer oder eine RAKE-Schaltung ist.

8. Einrichtung nach einem der vorhergehenden Ansprüche, enthalten in einem Mobilfunkempfänger.

9. Verfahren zur Skalierung von Soft-Output-Werten einer Empfängerstruktur, bei welchem in einem Schritt ein Skalierwert (var) für die Skalierung von digitalen Soft-Output-Werten (si) der Empfängerstruktur berechnet wird,
**gekennzeichnet durch** die weiteren Schritte:

- bei Erhalt des berechneten Skalierwertes (var) Ermitteln von Steuerparametern (n, $m_i$, j), die von diesem berechneten Skalierwert abhängig sind, in einem Software-gesteuerten Prozessor (ST) zur Programmierung einer in Hardware ausgeführten Arithmetik-Einheit (AE), derart, dass die Arithmetik-Einheit (AE) näherungsweise eine Skalierung der Soft-Output-Werte (si) entsprechend dem berechneten Skalierwert (var) über die Steuerparameter (n, $m_i$, j) vorzunehmen vermag, wobei die Ermittlung eines ersten Steuerparameters n durch Approximation des Skalierwerts (var) **durch** eine Zahl $2^n$ erfolgt und die Ermittlung eines Steuerparameterwortes $m_1, ..., m_p$ der Wortbreite p **durch** eine Zerlegung des Wertes $2^n$/var in einen Ausdruck $1 + \sum\limits_{i=1}^{p} m_i \cdot 2^{-i}$ erfolgt, wobei p eine ganze Zahl gleich oder größer als 1 ist und $m_i$ die Werte 0 oder 1 annehmen kann;

- Programmieren der Arithmetik-Einheit (AE) mit den ermittelten Steuerparametern (n, $m_i$, j);
- rechts oder links Verschieben von einem digitalen Eingangswert in Abhängigkeit des ersten Steuerparameters **durch** einen ersten Skalierschaltkreis der Arithmetik-Einheit; und

- Multiplizieren des verschobenen digitalen Eingangswertes mit einem Korrekturfaktor $1 + \sum\limits_{i=1}^{p} m_i \cdot 2^{-i}$ in einem zweiten Skalierschaltkreis der Arithmetik-Einheit, der p parallel angeordnete Stellenverschieber und einen Addierer mit mindestens p+1 Eingängen aufweist.

10. Verfahren nach Anspruch 9,
**gekennzeichnet durch** den Schritt:

- Wahl einer Begrenzung des Wertebereichs der von der Arithmetik-Einheit (AE) ausgegebenen Bitworte über das Einstellen eines zweiten Steuerparameters (j).

11. Verfahren nach Anspruch 9 oder 10,
**dadurch gekennzeichnet,**

- **dass** die Empfängerstruktur ein Entzerrer, insbesondere Viterbi-Entzerrer, ein Kanaldekodierer, insbesondere Viterbi-Kanaldekodierer oder eine RAKE-Schaltung ist.

## Claims

1. Device for scaling of soft output values from a receiver structure, with the device comprising a calculation means (KS) for calculation of a scaling value (var) for the scaling of digital soft output values (si) from the receiver structure, **characterized in that** the scaling device further comprises:

- a software-controlled processor (ST) for programming an arithmetic unit (AE), which, on receiving the calculated scaling value (var) from the calculation means (KS), reprograms the arithmetic unit (AE) by calculation of control parameters (n, $m_i$, j) which are dependent on this calculated scaling value; and
- the arithmetic unit (AE), which is designed using hardware, for scaling the digital soft output values (si) as a function of the calculated control parameters (n, $m_i$, j), wherein the arithmetic unit (AE) comprises a first scaling circuit (SR1), which shifts a digital input value to the right or left through a number (n) of digits which is dependent on the calculated scaling value (var), and a second scaling circuit (SR2_1/MUX1, SR2_2/MUX2, SR2_3/MUX3, ADD), which multiplies the shifted digital input value by a correction factor

$$1 + \sum\limits_{i=1}^{p} m_i \cdot 2^{-i}$$ , where p is an integer equal to or greater than unity, and $m_i$ can assume the values 0 or 1 as a function of the calculated scaling value (var), and wherein the second scaling circuit (SR2_1/MUX1, SR2_2/MUX2, SR2_3/MUX3, ADD) has p parallel-arranged digit shifters and an adder (ADD) with at least p+1 inputs.

2. Device according to Claim 1,
**characterized**

- **in that** the arithmetic unit (AE) comprises a first saturation stage (SAT1) which results in particular in fixed predetermined limiting of the value range of the bit words which are emitted from the first scaling circuit (SR1).

3. Device according to Claim 1 or 2,
**characterized**

- **in that** p = 2 or 3.

4. Device according to one of the preceding claims, **characterized**

   - **in that** the arithmetic unit (AE) comprises a second saturation stage (SAT2) which, in particular, results in selectable limiting (j) of the value range of the bit words which are emitted from the second scaling circuit (SR2_1/MUX1, SR2_2/MUX2, SR2_3/MUX3, ADD).

5. Device according to Claim 4, **characterized**

   - **in that** the second saturation stage (SAT2) is designed such that more than two, and in particular four, value range limits (j) can be set.

6. Device according to Claim 4 or 5, **characterized**

   - **in that** a rounding unit (MUX4, SR3) is provided in the arithmetic unit (AE), in particular in the signal path between the first scaling circuit (SR1) and the second saturation stage (SAT2), and is designed to add the value $2^q$ to a digital word, and then to carry out a digit shift of the digital word through q+1 digits to the right, where q is an integer greater than or equal to 2.

7. Device according to one of the preceding claims, **characterized**

   - **in that** the receiver structure is an equalizer, in particular a Viterbi equalizer, a channel decoder, in particular a Viterbi channel decoder, or a RAKE circuit.

8. Device according to one of the preceding claims, contained in a mobile radio receiver.

9. Method for scaling of soft output values from a receiver structure, in which a scaling value (var) for the scaling of digital soft output values (si) from the receiver structure is calculated in one step, **characterized by** the further steps of:

   - determination, on receiving the calculated scaling value (var), of control parameters (n, $m_i$, j ), which are dependent on this calculated scaling value, in a software-controlled processor (ST) for programming of an arithmetic unit (AE) which is designed in hardware, such that the arithmetic unit (AE) can carry out approximate scaling of the soft output values (si) corresponding to the calculated scaling value (var) via the control parameters (n, $m_i$, j), wherein a first control parameter n is determined by approximation of the scaling value (var) by a number $2^n$ and a control parameter word $m_1$, ..., $m_p$ of word length p is determined by breaking down the value

   $2^n$/var into an expression $1 + \sum_{i=1}^{p} m_i \cdot 2^{-i}$ , where p is an integer equal to or greater than unity, and $m_i$ may

   assume the values 0 or 1;
   - programming of the arithmetic unit (AE) with the determined control parameters (n, $m_i$, j);
   - right or left shifting of a digital input value as a function of the first control parameter by means of a first scaling circuit in the arithmetic unit; and

   - multiplication of the shifted digital input value by means of a correction factor $1 + \sum_{i=1}^{p} m_i \cdot 2^{-i}$ in a second scaling circuit in the arithmetic unit, which has p parallel-arranged position shifters and an adder with at least p+1 inputs.

10. Method according to Claim 9, **characterized by** the following step:

- selection of a limit for the value range of the bit words which are emitted from the arithmetic unit (AE), via the adjustment of a second control parameter (j).

**11.** Method according to Claim 9 or 10,
**characterized**

- **in that** the receiver structure is an equalizer, in particular a Viterbi equalizer, a channel decoder, in particular a Viterbi channel decoder, or a RAKE circuit.

**Revendications**

**1.** Dispositif de mise à l'échelle de valeurs de sortie logicielles d'une structure réceptrice, le dispositif comprenant un moyen de calcul (KS) pour calculer une valeur d'échelle (var) pour la mise à l'échelle de valeurs de sortie logicielles numériques (si) de la structure réceptrice,
**caractérisé par le fait que** le dispositif de mise à l'échelle comprend en plus :

- un processeur commandé par logiciel (ST) qui est destiné à la programmation d'une unité arithmétique (AE) et qui effectue lors de la réception de la valeur d'échelle calculée (var) par le moyen de calcul (KS) une reprogrammation de l'unité arithmétique (AE) en calculant des paramètres de commande (n, $m_i$, j) qui sont dépendants de cette valeur d'échelle calculée ; et
- l'unité arithmétique (AE) réalisée sous forme matérielle et destinée à la mise à l'échelle des valeurs de sortie logicielles numériques (si) en fonction des paramètres de commande calculés (n, $m_i$, j), l' unité arithmétique (AE) comprenant un premier circuit de mise à l'échelle (SR1) qui décale une valeur d'entrée numérique d'un certain nombre (n), dépendant de la valeur d'échelle calculée (var), de positions vers la droite ou vers la gauche et un deuxième circuit de mise à l'échelle (SR2_1 / MUX1, SR2_2 / MUX2, SR2_3 / MUX3, ADD) qui multiplie la valeur d'entrée numérique décalée par un facteur de correction $1 + \sum_{i=1}^{p} m_i \cdot 2^{-i}$, p étant un nombre entier supérieur ou égal à 1 et $m_i$ pouvant prendre les valeurs 0 ou 1 en fonction de la valeur d'échelle calculée (var), le deuxième circuit de mise à l'échelle (SR2_1 / MUX1, SR2_2 / MUX2, SR2_3 / MUX3, ADD) comportant p dispositifs de décalage de positions montés en parallèle et un additionneur (ADD) avec au moins p + 1 entrées.

**2.** Dispositif selon la revendication 1,
**caractérisé par le fait que**

- l'unité arithmétique (AE) comprend un premier étage de saturation (SAT1) qui provoque une limitation, notamment prédéterminée et fixe, du domaine de valeurs des mots de bits fournis par le premier circuit de mise à l'échelle (SR1).

**3.** Dispositif selon la revendication 1 ou 2,
**caractérisé par le fait que**

- p est égal à 2 ou 3.

**4.** Dispositif selon l'une des revendications précédentes,
**caractérisé par le fait que**

- l'unité arithmétique (AE) comprend un deuxième étage de saturation (SAT2) qui provoque une limitation (j), notamment sélectionnable, du domaine de valeurs des mots de bits fournis par le deuxième circuit de mise à l'échelle (SR2_1 / MUX1, SR2_2 / MUX2, SR2_3 / MUX3, ADD).

**5.** Dispositif selon la revendication 4,
**caractérisé par le fait que**

- le deuxième étage de saturation (SAT2) est conçu de telle sorte que plus de deux, notamment quatre, limitations de domaine de valeurs (j) sont réglables.

6. Dispositif selon la revendication 4 ou 5,
**caractérisé par le fait que**,

- dans l'unité arithmétique (AE), notamment dans le trajet de signal entre le premier circuit de mise à l'échelle (SR1) et le deuxième étage de saturation (SAT2), il y a une unité de calcul d'arrondi (MUX4, SR3) qui est conçue pour ajouter à un mot numérique la valeur $2^q$ puis pour effectuer un décalage de positions du mot numérique de q + 1 positions vers la droite, q étant un nombre entier supérieur ou égal à 2.

7. Dispositif selon l'une des revendications précédentes,
**caractérisé par le fait que**

- la structure réceptrice est un égaliseur, notamment un égaliseur de Viterbi, un décodeur de canal, notamment un décodeur de canal de Viterbi, ou un circuit RAKE.

8. Dispositif selon l'une des revendications précédentes, contenu dans un récepteur de radiocommunication mobile.

9. Procédé de mise à l'échelle de valeurs de sortie logicielles d'une structure réceptrice, dans lequel on calcule dans une première étape une valeur d'échelle (var) pour la mise à l'échelle de valeurs de sortie logicielles numériques (si) de la structure réceptrice,
**caractérisé par** les autres étapes suivantes :

- lors de la réception de la valeur d'échelle calculée (var), détermination de paramètres de commande (n, $m_i$, j), qui sont dépendants de cette valeur d'échelle calculée, dans un processeur commandé par logiciel (ST) pour la programmation d'une unité arithmétique (AE) réalisée sous forme matérielle de telle sorte que l'unité arithmétique (AE) est capable d'effectuer approximativement une mise à l'échelle des valeurs de sortie logicielles (si) suivant la valeur d'échelle calculée (var) par l'intermédiaire des paramètres de commande (n, $m_i$, j), la détermination d'un premier paramètre de commande n s'effectuant au moyen d'une approximation de la valeur d'échelle (var) par un nombre $2^n$ et la détermination d'un mot de paramètres de commande $m_1$, ..., $m_p$ de largeur

p s'effectuant au moyen d'une décomposition de la valeur $2^n$ / var en une expression $1 + \sum_{i=1}^{p} m_i \cdot 2^{-i}$,

p étant un nombre entier supérieur ou égal à 1 et $m_i$ pouvant prendre les valeurs 0 ou 1 ;
- programmation de l'unité arithmétique (AE) avec les paramètres de commande déterminés (n, $m_i$, j) ;
- décalage à droite ou à gauche d'une valeur d'entrée numérique en fonction du premier paramètre de commande par un premier circuit de mise à l'échelle de l'unité arithmétique ; et

- multiplication de la valeur d'entrée numérique décalée par un facteur de correction $1 + \sum_{i=1}^{p} m_i \cdot 2^{-i}$

dans un deuxième circuit de mise à l'échelle de l'unité arithmétique, lequel comporte p dispositifs de décalage de positions montés en parallèle et un additionneur avec au moins p + 1 entrées.

10. Procédé selon la revendication 9,
**caractérisé par** l'étape suivante :

- sélection d'une limitation du domaine de valeurs des mots de bits fournis par l'unité arithmétique (AE) par l'intermédiaire du réglage d'un deuxième paramètre de commande (j).

11. Procédé selon la revendication 9 ou 10,
**caractérisé par le fait que**

- la structure réceptrice est un égaliseur, notamment un égaliseur de Viterbi, un décodeur de canal, notamment un décodeur de canal de Viterbi, ou un circuit RAKE.

Fig. 1

$$si/var = (si/2^n) \cdot (2^n/var)$$

$$2^n/var = 1 + a \cdot 0,5 + b \cdot 0,25 + c \cdot 0,125$$

Fig. 3

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5577068 A
- WO 0074247 A1